# EUROPÄISCHE PATENTSCHRIFT

(11) **EP 2 470 740 B1**
(45) Veröffentlichungstag und Bekanntmachung des Hinweises auf die Patenterteilung: **07.10.2015**
(21) Anmeldenummer: 10745560.2
(22) Anmeldetag: 16.08.2010
(51) Int. Cl.: E06B 5/18, H05K 9/00, E05D 15/10, E05D 15/56

(54) **Elektromagnetisch dichte Tür für eine Messkammer**
Electromagnetically sealed door for a measurement chamber
Porte à étanchéité électromagnétique pour une chambre de mesure

(30) Priorität: 26.08.2009 DE 102009038916
(43) Veröffentlichungstag der Anmeldung: 04.07.2012
(73) Patentinhaber: Rohde & Schwarz GmbH & Co. KG, 81671 München (DE)
(72) Erfinder: HAMMER, Andreas, 94104 Tittling (DE); BARTSCH, Alexander, 94518 Spiegelau (DE); MUHR, Hermann, 94267 Prackenbach (DE)
(74) Vertreter: Körfer, Thomas
(86) Internationale Anmeldenummer: PCT/EP2010/005024
(87) Internationale Veröffentlichungsnummer: WO 2011/023314

(56) Entgegenhaltungen:
- EP-A1- 0 512 406
- EP-A2- 0 379 898
- EP-A2- 0 720 422
- WO-A2-2004/090270
- DE-A1- 3 204 274
- DE-C1- 3 916 836
- US-A- 3 531 577
- US-A- 4 561 209

## Beschreibung

Die Erfindung betrifft einen Verschlussmechanismus für eine elektromagnetisch abgedichtete Messeinrichtung, die aus einer Messkammer, einer Tür zum Schließen der Messkammer sowie einer elektromagnetischen Dichtung, die bevorzugt an einem Türrahmen der Messkammer angebracht ist, besteht.

Elektromagnetisch abgedichtete Messeinrichtungen werden häufig im technischen oder auch medizinischen Bereich verwendet, um elektromagnetische Eigenschaften ohne den Einfluss von umgebender Störstrahlung genau zu ermitteln. Zum Beispiel werden die Hochfrequenzeigenschaften von Mobilfunkendgeräten während der Entwicklung genau charakterisiert, um Fehler oder Unregelmäßigkeiten in den entsprechenden Baugruppen frühzeitig zu erkennen und zu beheben.

Eine solche Messkammer besteht aus einem metallischen Außengehäuse. Die Gehäusewand ist auf der Innenseite mit Absorbermaterial ausgekleidet um reflektierte Strahlung zu vermeiden. Ein zu prüfendes Gerät wird dabei über eine Tür in den Innenraum der Messkammer eingebracht. Eine solche Tür stellt eine potentielle Schwachstelle in der Abschirmung der Messkammer dar und muss deshalb elektromagnetisch dicht verschließbar ausgeführt sein.

In der DE 39 19 184 A1 ist eine begehbare Messkammer für eine biomagnetische Messeinrichtung beschrieben, die aus mehreren Schalen zur Abschirmung der magnetischen und elektrischen Komponenten elektromagnetischer Aussenfelder besteht und mit einer horizontal zweiteiligen Tür versehen ist. Jede Halbtür ist an Scharnierbändern befestigt, die mittels Scharnieren um den Scharnierträger schwenkbar sind, der mit Hilfe von Laschen an der Kammerwand gehaltert ist. Jede Halbtür ist mit einem eigenen Türgriff ausgestattet, der wiederrum mit einem eigenen Schließmechanismus versehen ist, der einen Schließzylinder in den zugeordneten Verriegelungsblock führt. Um den Schlitz zwischen den beiden Halbtüren elektromagnetisch dicht zu gestalten, sind die dem Schlitz zugewandten Kanten der Halbtüren mit Lippen aus flexiblem Dichtmaterial versehen. Darüberhinaus ist der Schlitz zwischen den Halbtüren durch eine schwenkbare, an einem Scharnier befestigte Abdeckplatte versehen. Um sicher zu stellen, dass ein ausreichender elektromagnetischer Kontakt zwischen den Halbtüren besteht, ist die Abdeckplatte mit Stiften versehen, die in den Schlitz zwischen den Halbtüren eintauchen und für einen zusätzlichen Kontakt der beiden Seiten sorgen.

Um für die gesamte Tür eine solch gute elektromagnetische Abdichtung zu erreichen, muss auch der Außenrand der Türhälften mit Dichtstiften sowie der Türrahmen mit Dichtmaterial versehen sein. Beim Öffnen der Türen über ein normales Drehscharnier ergibt sich dabei jedoch der Nachteil, dass die in das Dichtmaterial eingreifenden Stifte das Dichtmaterial einseitig durch Zusammendrücken der Dichtung auf der dem Scharnier zugewandten Seite stärker belasten und sich das Dichtmaterial dadurch schneller abnutzt. Schon bei einer mittleren Nutzung der elktromagnetischen Messeinrichtung mit 80 Öffnungszyklen pro Tag ist das Dichtmaterial nach kurzer Zeit derart verformt, dass die elektromagnetische Dichtheit nicht mehr gewährleistet ist.

EP O 379 898 A2 beschreibt eine geschirmte Tür mit Türrahmen für abgeschirmte Räume, bei der die Anlenkung der Tür an den Türrahmen durch ein Scharnierband 30, das aus einem fest mit dem Türrahmen verbundenen festen Lagerteil 31, einem fest mit der Tür verbundenen beweglichen Lagerteil 32 und einem Lenker 33 besteht, der um die Gelenkbolzen 34, 35 schwenkbar gelenkig mit dem festen Scharnierteil 31 und dem beweglichen Scharnierteil 32 verbunden ist. Siehe dazu Spalte 8, Zeilen 28-36 und Fig.13-13d. Beim Öffnen der Tür schwenkt der Lenker 33 um den ersten und zweiten Gelenkbolzen 34, 35. Durch die Drehung um den Bolzen 35 wird das Türblatt parallel zum Türrahmen ausgerichtet. Zum Schließen der Tür wird dann der Lenker 33 um den Gelenkbolzen 34 gedreht. Dadurch wird die Tür schräg, also mit einer Komponente parallel zum Türblatt in die Nut bzw. beim Offnen der Tür aus der Nut herausgeführt, nicht aber senkrecht zur Türebene bewegt. Durch eine solche aus einem oder zwei Gelenken bestehende gelenkige Führung der Tür ist somit immer eine seitliche Bewegung und somit nicht ausschließlich senkrechte Bewegung der Tür verbunden, wie nachfolgend genauer erläutert. Die Tür weist umfänglich einen Falz auf, der als Steg mit trapezförmigen Schenkeln 12, 40, 41 ausgebildet ist und in eine Nut 4 im Türrahmen eingreift. Wie in Spalte 8, Zeile 45 bis Spalte 9, Zeile 4 beschrieben, ist die Tür um den Bolzen 34 schwenkbar und wird durch eine Rotationsbewegung bewegt, bis das Türblatt unmittelbar vor der Schließstellung eine zu der Ebene des Türrahmens parallele Stellung einnimmt, in dem der Lenker 33 und das bewegliche Lagerteil 32 um den Scharnierbolzen 35 um einen Winkel alpha ausgelenkt wird, der auch dem Winkel des Lenkers zur Parallelstellung vom Türrahmen entspricht, wie in Fig. 13C gezeigt. Das Türblatt wird in dieser Parallelstellung durch eine weitere Drehbewegung um den Scharnierbolzen 34 in einer Bewegung mit einem Bewegungsanteil in Richtung senkrecht zur Türebene und einer Bewegungskomponete parallel zur Türebene bewegt. Die Verschiebung des Türblatts und somit des Stegs bzw. Falzes parallel zur Türebene entspricht dabei delta 1=1*(1-cos.alpha), wobei 1 die Länge des Lenkers 33 zwischen den Drehbolzen 34 und 35 ist und alpha der Auslenkwinkel zwischen Türebene und Lenker 33 zu dem Zeitpunkt ist, in dem das Türblatt parallel zum Türrahmen ausgerichtet ist. Diese Türführung mit einer Bewegungskomponente parallel zur Türebene hat den Nachteil, dass der Falz in der Nut seitlich verschoben wird und somit eine darin befindliche Dichtung einseitig stärker belastet wird und somit ein signifikanter Verschleiß auftritt. Der abschließende Teil des Schließvorgangs wird also durch eine Rotation um die Gelenkbolzen 34 und 35 ausgeführt und die Parallelbewegung des Türblatts und somit des Falzes durch die Drehung des Lenkers 33 wird dabei nicht durch die gegensinnige Drehung um den Gelenkbolzen 35 aufgehoben, da dieser lediglich die Parallelstellung der Tür zum Türrahmen bewirkt. Somit wird die Tür in EP O 379 898 A2 nicht genau senkrecht zur Türebene von der Messkammer weg bzw. hinbewegt.

Es stellt sich daher die Aufgabe, einen Verschlussmechanismus für eine elektromagnetisch dicht schließende Tür einer Messeinrichtung aufzuzeigen, der eine hohe elektromagnetische Abdichtung garantiert und das Dichtmaterial wenig belastet und somit wenig verschleißt.

Die Aufgabe wird durch den erfindungsgemäßen Verschlussmechanismus gemäß Anspruch 1 gelöst. In den Unteransprüchen sind vorteilhafte Weiterbildungen des erfindungsgemäßen Mechanismus dargestellt.

Der erfindungsgemäße Verschlussmechanismus für eine elektromagnetisch abgedichtete Messeinrichtung, die aus einer Messkammer, einer Tür zum Schließen der Messkammer, sowie einer elektromagnetischen Dichtung, die bevorzugt an einem Türrahmen der Messkammer angebracht ist, besteht, bewegt die Tür zuerst linear, in Richtung senkrecht zur Türebene, vom Türrahmen weg und schwenkt sie danach in einer Rotationsbewegung auf. Durch die zuerst lineare Bewegung wird das Dichtmaterial entlastet. Erst bei einer ausreichenden Entfernung der Tür vom Dichtmaterial setzt die Rotationsbewegung ein. Beim Schließen der Tür sind während der Rotationsbewegung die Tür und die Dichtung nicht in Kontakt, sodass ein Eindrehen der Dichtung, wie es bei einer herkömmlichen Schwenktür oft der Fall ist, nicht auftritt.

Der erfindungsgemäße Verschlussmechanismus eignet sich besonders vorteilhaft, wenn die elektromagnetische Dichtung in mindestens einer umfänglichen Nut im Türrahmen der Messkammer angebracht ist und die Tür umfänglich mindestens einen Falz aufweist, der in die mindestens eine Nut im Türrahmen eingreift. Das Eingreifen des Türfalzes in eine mit Dichtmaterial versehene Nut im Türrahmen, bildet eine sehr gute elektromagnetische Abdichtung, die aber durch eine reine Drehbewegung beim Öffnen der Tür leidet. Durch den erfindungsgemäßen Verschlussmechanismus kann der mindestens eine Falz und entsprechend die mindestens eine Nut im Türrahmen lang bzw. tief genug ausgeführt werden, um auch höchsten Dichtheitsansprüche zu genügen.

Vorteilhafterweise ist die Tür in einem Hilfsrahmen eingebaut und senkrecht zur Ebene der geschlossenen Tür im Hilfsrahmen bewegbar. Der Hilfsrahmen ist durch mehrere Drehscharniere mit einer Seitenwand der Messkammer schwenkbar verbunden. Dieser Aufbau ermöglicht es, herkömmliche Drehscharniere für die Rotationsbewegung der Messkammertür zu verwenden. Durch die Wahl der Dicke des Hilfsrahmens kann der Verschlussmechanismus für Türen mit unterschiedlich tiefem Falz bzw. unterschiedlich tiefen Nuten in dem Türrahmen verwendet werden.

Vorteilhafterweise ist oberhalb und unterhalb der Tür ein erstes und ein zweites Führungssystem an der Messkammer angebracht. Eine Mehrzahl von Führungszapfen ist mit der Tür form- oder stoffschlüssig verbunden. Durch das Anbringen des Führungssystems an der Messkammer ist die Tür lediglich mit dem Gewicht der Führungszapfen beaufschlagt, sodass die Messeinrichtung bei geöffneter Tür nicht in Richtung der Tür kippt.

Vorteilhafterweise umfasst ein Führungssystem mindestens zwei Schienenabschnitte, die an einem Ende über ein Koppelelement beweglich miteinander verbunden sind. An den dem Koppelelement entgegengesetzten Endbereichen der Schienenabschnitte ist jeweils ein Schrägschlitz ausgebildet. Durch Drehen des beweglich gelagerten Koppelelements werden die mindestens zwei Schienenabschnitte parallel zur Tür nach außen geführt. Die Führungszapfen greifen in jeweils einen Schrägschlitz im Führungssystem ein und werden linear in Richtung senkrecht zur Tür geführt. Der beschriebene Mechanismus ermöglicht es, mit wenig Kraftaufwand die Tür gegen die Reibungskraft zwischen Türfalz und Dichtungsmaterial aus der Nut im Türrahmen heraus zu bewegen. Auch eine schwere Tür kann auf diese Weise mühelos aus dem Türrahmen herausgezogen werden. Diese lineare Bewegung der Tür ermöglicht es, die Nut bzw. den Türfalz über den gesamten Umfang des Türrahmens bzw. der Tür, insbesondere auch in den Ecken, auszubilden und somit die Tür lückenlos elektromagnetisch abzudichten.

Ausführungsbeispiele des erfindungsgemäßen Verschlussmechanismus sind in der Zeichnung vereinfacht beispielhaft dargestellt und werden anhand der nachfolgenden Beschreibung näher erläutert. Es zeigen:
- Fig. 1: einen schematischen Ablauf des erfindungsgemäßen Verschlussmechanismus in Draufsicht;
- Fig. 2: ein Ausführungsbeispiel einer elektromagnetisch abgedichteten Messeinrichtung mit einem erfindungsgemäßen Verschlussmechanismus in perspektivischer Ansicht;
- Fig. 3: ein erstes Ausführungsbeispiel eines erfindungsgemäßen Verschlussmechanismus im geschlossenen Zustand in Draufsicht;
- Fig. 4: ein erstes Ausführungsbeispiel eines erfindungsgemäßen Verschlussmechanismus während der linearen Bewegungsphase in Draufsicht;
- Fig. 5: ein erstes Ausführungsbeispiel eines erfindungsgemäßen Verschlussmechanismus am Ende der linearen Bewegungsphase in Draufsicht;
- Fig. 6: ein erstes Ausführungsbeispiel eines erfindungsgemäßen Verschlussmechanismus in der Rotationsphase in Draufsicht;
- Fig. 7: ein zweites Ausführungsbeispiel eines erfindungsgemäßen Verschlussmechanismus im geschlossenem Zustand in perspektivischer Ansicht;
- Fig. 8: ein zweites Ausführungsbeispiel eines erfindungsgemäßen Verschlussmechanismus während der linearen Bewegungsphase in perspektivischer Ansicht;
- Fig. 9: ein zweites Ausführungsbeispiel eines erfindungsgemäßen Verschlussmechanismus in perspektivischer Ansicht am Ende der linearen Bewegungsphase und
- Fig. 10: ein Ausführungsbeispiel eines erfindungsgemäßen Scharniers in perspektivischer Ansicht.

Einander entsprechende Teile sind in allen Figuren mit den gleichen Bezugszeichen versehen.

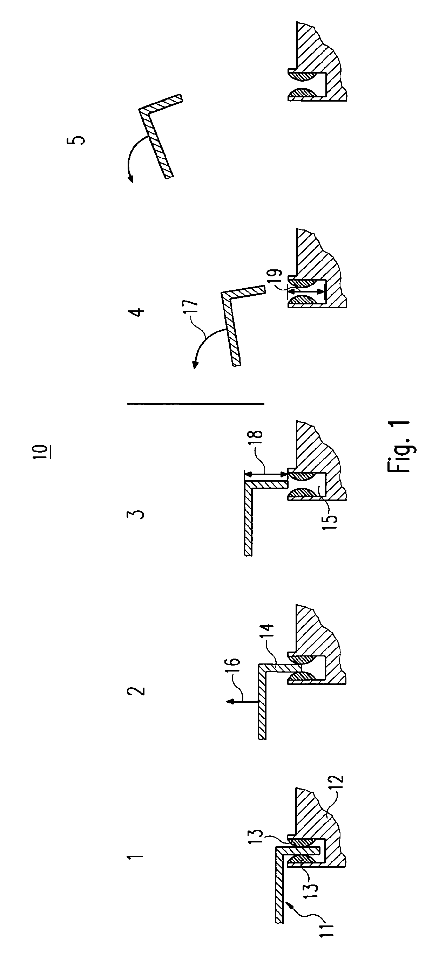

Fig. 1 zeigt einen schematischen Ablauf 10 eines erfindungsgemäßen Verschlussmechanismus in fünf Phasen. In der mit 1 überschriebenen 1. Phase der Schnitt-Zeichnung ist eine Tür 11 dargestellt die einen Türfalz 14 aufweist. Dieser Türfalz 14 kann um den gesamten Umfang der Tür ausgebildet sein. Der Türrahmen 12 weist eine Nut 15 auf, die entsprechend dem Türfalz 14 ganz oder teilweise umfänglich am Türrahmen 12 ausgebildet ist. In der Nut ist eine Dichtung 13, hier in zweiteiliger Form, eingesetzt und fixiert. Die Tiefe 18, 19 des Türfalzes 14 und der Nut 15 im Türrahmen 12 sowie die Art und Form der Dichtung 13 sind entsprechend der geforderten elektromagnetischen Dichtheit wählbar. Es können auch mehrere Nute 15 im Türrahmen und die entsprechende Anzahl an Türfalze 14an der Tür 11 vorgesehen sein.

Aus dieser geschlossenen Position in Phase 1, wird die Tür 11 in einer linearen Bewegung senkrecht zur Türebene in Pfeilrichtung 16, wie in der Phase 2 dargestellt, aus der Nut 15 in Türrahmen 12 herausgeführt. In Phase 3 befindet sich der Türfalz 14 vollständig vor dem Türrahmen 12. Nun setzt die Rotationsbewegung, verdeutlicht durch den Pfeil 17 in Phase 4 des Bewegungsablaufes, ein. Mit der weiteren Rotationsbewegung 17, siehe Phase 5, wird die Tür bis zu ihrem Anschlag, der bevorzugt bei mindestens 90° liegen sollte, aufgeschwenkt.

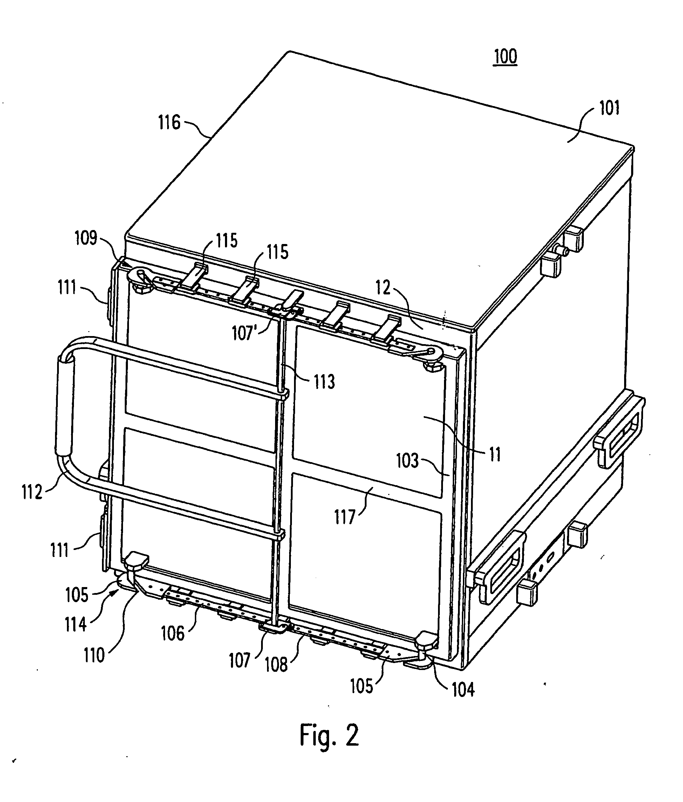

Fig. 2 zeigt eine Messeinrichtung 100, deren Tür mit einem erfindungsgemäßen Verschlussmechanismus versehen ist. Die Messkammer 101 ist auf der dem Betrachter zugewandten

Seite mit einer Tür 11 verschlossen. Ein Hilfsrahmen 103 mit einem Stützkreuz 117 umfasst die Tür 11. Der Hilfsrahmen 103 besitzt eine Tiefe 19, die mindestens der Tiefe der Tür 11 einschließlich der Tiefe des Türfalzes 14 entspricht. Die Tür 11 ist gleitend im Hilfsrahmen 103, zum Beispiel über Gleitschienen oder kurze Teleskopauszüge, an mehreren Punkten gelagert. Der Hilfsrahmen 103 wird über mindestens zwei Scharniere 111, die an einer Seitenwand 116 befestigt sind, gehalten. An der Tür 11 sind eine Mehrzahl von Führungszapfen 104 form- oder stoffschlüssig angebracht. Vier Führungszapfen 104 können zum Beispiel jeweils in einer Ecke der Tür 11 angeschweisst, angeschraubt, angenietet oder auch angeklebt sein.

Am Türrahmen 12 der Messkammer 101 befinden sich oberhalb und unterhalb der Tür 11 ein erstes bzw. zweites Führungssystem 109, 114. Ein Führungssystem 109, 114 besteht aus jeweils einem ersten und einem zweiten Schienenabschnitt 106, 108, die durch ein Koppelelement 107, 107' verbunden sind und jeweils einen Endbereich 105 aufweisen, in dem ein Schrägschlitz 110 eingearbeitet ist. Die Koppelelemente 107, 107' des ersten und zweiten Führungssystems 109, 114 sind durch eine Verbindungsstange 113 fest miteinander verbunden. Durch einen fest mit der Verbindungsstange 113 verbundenen Drehbügel 112 werden die Verbindungsstange 113 und somit auch die Koppelelemente 107, 107' um 180° gedreht. Die Verbindungsstange 113 ist zusätzlich an der Vorderseite des Hilfsrahmens 103 befestigt und klinkt zum Schwenken der Tür 11 aus den Koppelelementen 107, 107' aus.

Der Drehbügel 112 ist im Ausführungsbeispiel als langgezogenes U ausgeformt, sodass eine pro Drehwinkel aufzubringende Kraft sehr gering ist. Das Koppelelement 107 bzw. 107' ist wiederrum mit den mindestens zwei Schienenabschnitten 106, 108 so verbunden, dass diese parallel zur Tür 11 nach außen geführt werden. Die beiden Schienenabschnitte 106, 108 sind dabei gleitend in einer Mehrzahl von Schienenhalterungen 115, die am Türrahmen 12 der Messkammer 101 angebracht sind, gehalten.

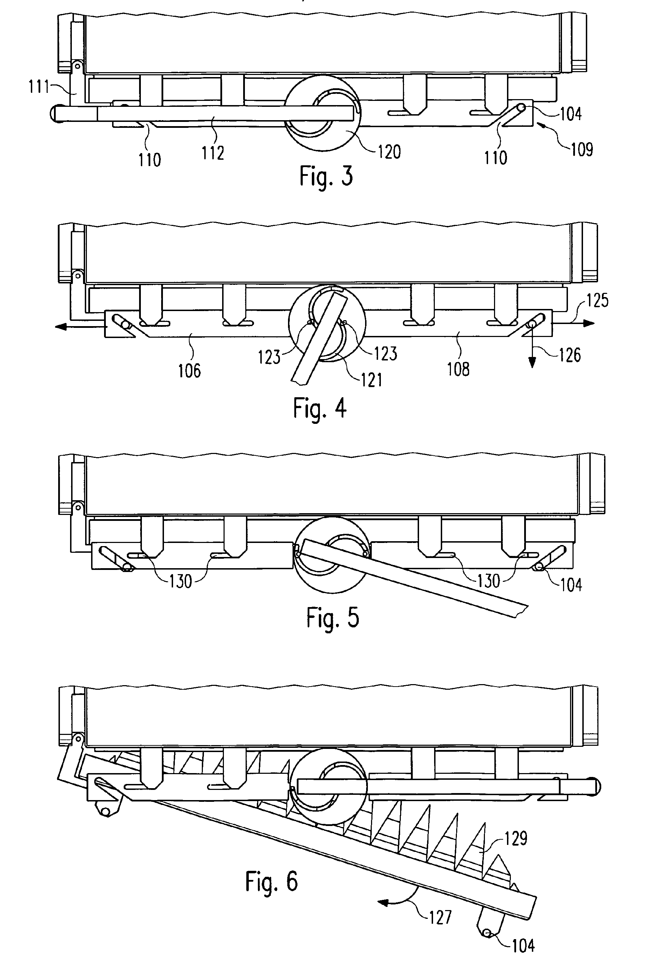

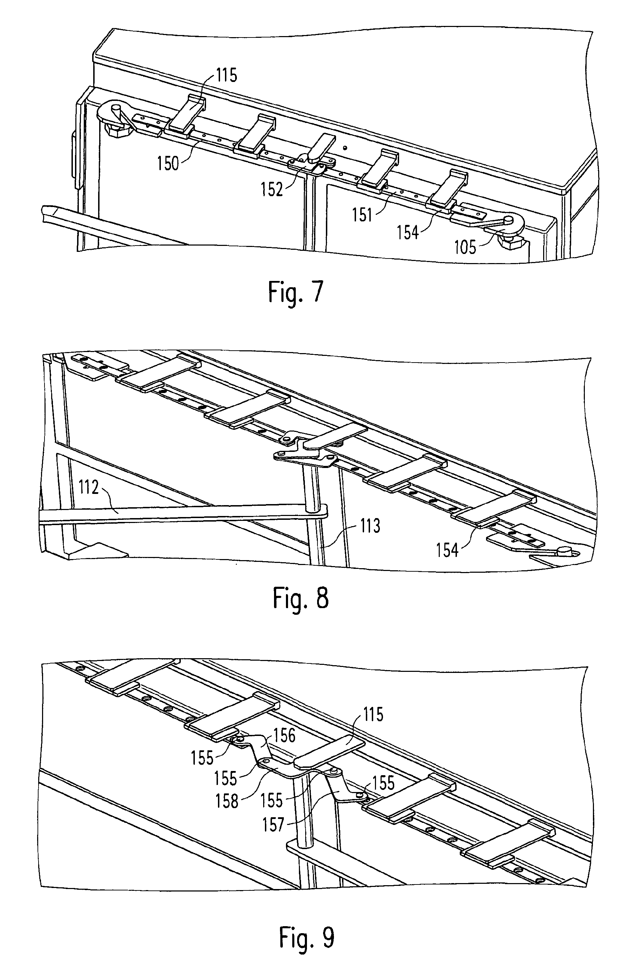

Der erfindungsgemäße Verschlussmechanismus ist für ein erstes Ausführungsbeispiel in den Fig. 3 - Fig. 6 und für ein zweites Ausführungsbeispiel in den Fig. 7 - Fig. 9 dargestellt, und wird nachfolgend im Detail beschrieben.

Ein Ausschnitt der Messkammer 101, der Hilfsrahmen 103, das Scharnier 111 sowie ein Führungssystem 104 mit Kulissenscheibe 120 als Koppelelement 107 und der Drehbügel 112 sind in Draufsicht dargestellt. Fig. 3 zeigt die geschlossene Tür mit dem nach links geklappten Drehbügel 112. Der erste bzw. zweite Schienenabschnitt 106, 108 weist Löcher 130 auf, in die Stifte der Schienenhalterung 115 eingreifen und die Schienenabschnitte 106, 108 somit führen und tragen. Im Endbereich des ersten bzw. zweiten Schienenabschnitts 106, 108 ist jeweils ein Schrägschlitz 110 ausgebildet. Ein Führungszapfen 104 durchgreift jeweils einen Schrägschlitz 110. Im geschlossenen Zustand der Tür 11 befindet sich der Führungszapfen 104 am der Öffnung des Schrägschlitzes gegenüberliegenden Ende. Die Kulissenscheibe 120 befindet sich in der Mitte zwischen dem ersten und zweiten Schienenabschnitt 106, 108, wobei jeweils ein Kulissenstein 123 am ersten bzw. zweiten Schienenabschnitt 106, 108 in einen Kulissenschlitz 121 der Kulissenscheibe 120 eingeführt ist.

Wird der Drehbügel 112, der in diesem Ausführungsbeispiel an den gegenüberliegenden Kulissenscheiben 120, 120' befestigt ist, wie in Fig. 4 dargestellt, aus seiner Ruheposition ausgeschwenkt, laufen die Kulissensteine 123 entlang den geschwungenen Kulissenschlitzen 121 radial nach außen. Der erste bzw. zweite Schienenabschnitt bewegt sich jeweils in Richtung des Pfeils 125 nach außen. Der Führungszapfen 104 wird dabei in Richtung des Pfeils 126 senkrecht zur Türebene nach außen geführt.

Fig. 5 zeigt den Verschlussmechanismus am Ende der linearen Phase. Der Führungszapfen 104 ist dabei am offenen Ende des Schrägschlitzes 110 angelangt, der Drehbügel 112 um nahezu 180° auf die andere Seite der Tür 11 geschwenkt.

Fig. 6 zeigt nun den Verschlussmechanismus in der Rotationsphase. Über einen nicht dargestellten Griff auf der rechten Seite wird die Tür 11 einschließlich Hilfsrahmen 103 um das Scharnier 111 in Pfeilrichtung 127 gedreht. Auf der Innenseite der Tür 11 angebrachtes Absorbermaterial 129 wird sichtbar.

Die Fig. 7 - 9 zeigen ein zweites Ausführungsbeispiel des erfindungsgemäßen Verschlussmechanismus. Dieses unterscheidet sich lediglich durch die Ausführung des ersten und zweiten Führungssystems 109, 114 vom ersten Ausführungsbeispiel. Die Tür 11, der Hilfsrahmen 103 sowie dessen Aufhängung durch die Scharniere 111 sind in gleicher Weise ausgeführt wie im ersten Ausführungsbeispiel.

Oberhalb und unterhalb der Tür 11 ist am Türrahmen 12 jeweils ein Führungssystem mittels Schienenhalterungen 115 befestigt. Der erste und zweite Schienenabschnitt ist als Gestängeabschnitt 150, 151 ausgeführt. Um die Gewichtsverteilung der Messkammer auszugleichen und das erste und zweite Führungssystem 109, 114 leicht zu halten, sind die Gestängeabschnitte 150, 151 als stabile, schmale, aus leichtem Material gefertigte Stangen ausgeführt. Die Gestängeabschnitte 150, 151 werden durch die Schienenhalterungen 115 und daran befestigte Führungselemente 154 geführt. Der Endbereich 105 eines jeden Gestängeabschnittes 150, 151 weist wiederrum einen Schrägschlitz 110 auf, in dem der Führungszapfen 104 geführt wird. Als Koppelelement wird ein Spreizgelenk 152 verwendet, das mittels Stiften 155 mit den beiden Gestängeabschnitten 150, 151 beweglich verbunden ist.

Das Spreizgelenk 152 besteht aus zwei L-förmigen Gelenkarmen 156, 157, die beweglich mit einem Mittelelement 158 verbunden sind. Das Mittelelement 158 ist Doppel-L-förmig ausgebildet, wobei die beiden L-förmigen Komponenten um 180° um die Mitte des kürzeren Schenkels gedreht angeordnet sind. Das Mittelelement 158 ist in der Mitte des kurzen Schenkels einerseits mit einer Schienenhalterung 115 drehbar, andererseits mit der Verbindungsstange 113 fest verbunden.

Zum Öffnen der Tür 11 wird der Drehbügel 112 in einer kreisförmigen Bewegung zur anderen Seite geschwenkt und dabei die Verbindungsstange und das daran befestigte Mittelelement 158 gedreht. Die an den langen Schenkeln des Mittelelements 158 drehbar über Stifte 155 angelenkten Gelenkarme 156, 157 werden dabei aufgespreizt und schieben die am Ende des kurzen Schenkels des ersten und zweiten Gelenkarms 156, 157 angelenkten ersten und zweiten Gestängeabschnitte 150, 151 nach außen. Der Führungszapfen 104 wird dabei wiederrum im Schrägschlitz 110 in Richtung senkrecht zur Tür vom Türrahmen 12 weg bewegt. Die Tür 11 bzw. der Türfalz 14 wird dabei aus der Nut im Türrahmen 12 senkrecht zur Türebene gleitend im Hilfsrahmen 103 herausgezogen. Sobald der Führungszapfen 104 das offene Ende des Schrägschlitzes 104 erreicht hat, kann die Tür über einen nicht dargestellten Griff um das Scharnier 111 geschwenkt werden.

Die vorliegende Erfindung beschränkt sich nicht auf die beiden aufgezeigten Ausführungsbeispiele. So können die Führungssysteme 109, 114 auch an den Seiten der Tür 11 am Türrahmen 12 befestigt sein und die Tür 11 nach oben bzw. nach unten ausgeschwenkt werden. In gleicher Weise ist in den beschriebenen Ausführungsbeispielen ein Öffnen der Tür 11 mit Rechtsanschlag möglich, indem die Scharniere 111 anstatt an der linken Seitenwand an der rechten Seitenwand befestigt werden. Ebenso kann der Drehbügel 112 durch einen Hebelgriff, der die Verbindungsstange 113 mittels Zahnräder dreht, ersetzt werden. Ein solcher Hebelgriff kann gleichzeitig zum Schwenken der Tür verwendet werden.

Um ein versehentliches Öffnen der Tür zu vermeiden, kann eine Arretiervorrichtung für den Drehbügel bzw. eine Hebelgriff vorgesehen werden. Ein Drehgriff kann z.B. in eine Klemmhalterung eingerastet und somit arretiert werden. Ein Hebelgriff kann beispielsweise durch ein Schloss verdrehsicher festgestellt werden.

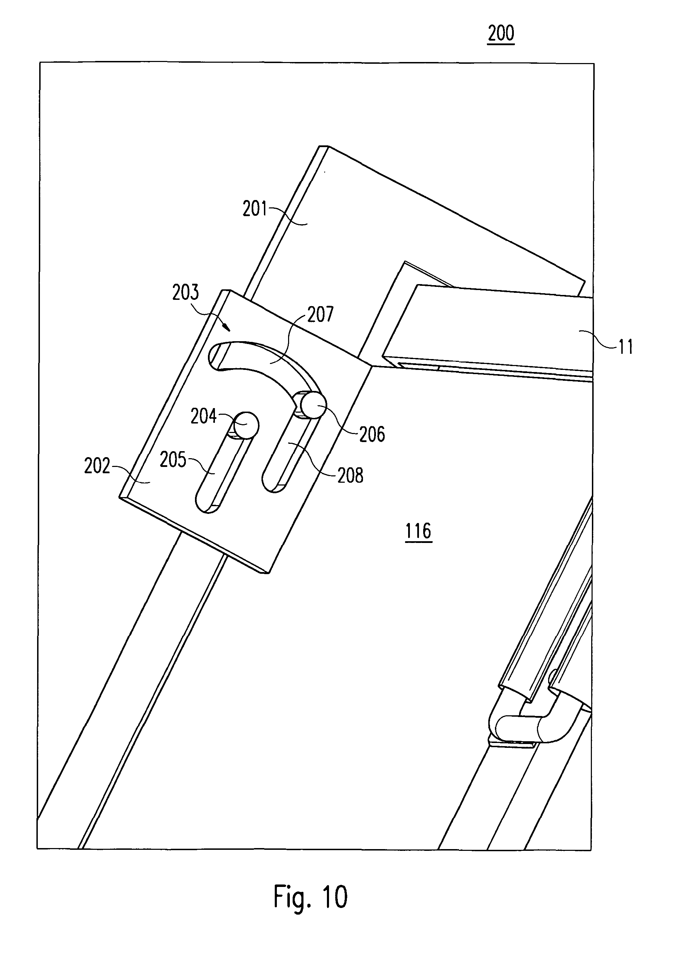

Anstatt ein herkömmliches Scharnier 111 an einem Hilfsrahmen 103 zu befestigen, kann ein Spezialscharnier 200 direkt an der Tür 11 befestigt werden. Wie in Fig. 10 dargestellt, besteht das Spezialscharnier 200 aus einem Scharnierarm 201, der mit der Tür 11 und einer Scharnierplatte 202, die mit der Seitenwand 116 der Messkammer 101 fest verbunden ist. Am Scharnierarm 201 sind zwei Scharnierzapfen 204, 206 ausgebildet, wobei ein erster Scharnierzapfen 204 in einen Längsschlitz 205 und ein zweiter Scharnierzapfen 206 in einen Drehschlitz 203 eingreift. Der Drehschlitz 203 ist aus einem Längsabschnitt 208 und einem anschließenden Bogenabschnitt 207 ausgebildet. Der Längsschlitz 205 und der Längsabschnitt 208 des Drehschlitzes 203 sind gleich lang und legen die maximale Auslenkung der Tür durch die lineare Bewegung senkrecht zur Türebene fest. Der Bogenabschnitt 207 ist als ein Kreissegment geformt, dessen überstreichender Winkel den Öffnungswinkel des Spezialscharniers 200 festlegt. Das dem Bogenabschnitt 207 zugewandte Ende des Längsschlitzes 205 bildet den Mittelpunkt des Kreissegments.

Durch einen nicht dargestellten Querbügel, der über die gesamte Türbreite reicht und an der Tür 11 befestigt ist, wird die verschlossene Tür 11 senkrecht zur Türebene nach vorne aus der Nut im Türrahmen gezogen, bis die Scharnierzapfen das Ende des Längsschlitzes 205 bzw. des Längsabschnitts 208 des Drehschlitzes 203 erreichen. Danach wird durch eine Bewegung im Bogenabschnitt 207 die Tür geschwenkt. Das Spezialscharnier 200 ist dabei so ausgerichtet, dass die Scharnierplatte 202 parallel zur Rotationsebene der Tür liegt.

Alle Elemente des erfindungsgemäßen Verschlussmechanismus, wie z.B. der zumindest eine Führungszapfen 104, das Führungssystem 109, 114 sowie die Scharniere 111, 200, sind außerhalb des abgeschirmten Bereichs und ohne Durchführung in den abgeschirmten Bereich der Messkammer hinein an der Tür 11 bzw. Hilfsrahmen 103 und der Seitenwand 116 der Messkammer 101 angebracht. Die genannten Elemente sind beispielsweise durch Schweißen, Löten oder durch Schrauben, die nicht die Messkammerwand durchdringen, befestigt. Somit sind weder zusätzliche elektromagnetische Abdichtungen notwendig, noch wird das elektromagnetische Feld im Inneren der Messkammer beeinflusst.

## Patentansprüche

1. Verschlussmechanismus für eine elektromagnetisch abgedichtete Messeinrichtung (100) mit einer Messkammer (101), einer Tür (11) zum Schließen der Messkammer (101) sowie einer elektromagnetischen Dichtung (13), wobei die Tür (11) umfänglich mindestens einen Falz (14) aufweist, der in mindestens eine Nut (15) im Türrahmen (12) eingreift,
**dadurch gekennzeichnet,**
**dass** die Tür (11) so angebracht ist, dass sie zuerst linear (16) von der Messkammer (101) wegbewegbar und danach in einer Rotationsbewegung (17) schwenkbar ist, sodass die Tür (11) in einer linearen Bewegung ausschließlich senkrecht zur Türebene aus der Nut (15) herausgeführt wird.

2. Verschlussmechanismus gemäß Anspruch 1,
**dadurch gekennzeichnet,**
**dass** die elektromagnetische Dichtung (13) in mindestens einer umfänglichen Nut (15) im Türrahmen (12) der Messkammer (101) angebracht ist.

3. Verschlussmechanismus gemäß Anspruch 1 oder 2,
**dadurch gekennzeichnet,**
**dass** zumindest ein Führungszapfen (104) mit der Tür (11) form- oder stoffschlüssig verbunden ist.

4. Verschlussmechanismus gemäß einem der Ansprüche 1 bis 3,
**dadurch gekennzeichnet,**
**dass** die Tür (11) in einen Hilfsrahmen (103) eingebaut und die Tür (11) senkrecht zur Ebene der geschlossenen Tür (11) im Hilfsrahmen (103) bewegbar ist.

5. Verschlussmechanismus gemäß Anspruch 4,
**dadurch gekennzeichnet,**
**dass** der Hilfsrahmen (103) durch mehrere Drehscharniere (111) mit einer Seitenwand (116) der Messkammer (101) schwenkbar verbunden ist.

6. Verschlussmechanismus gemäß einem der Ansprüche 1 bis 5,
**dadurch gekennzeichnet,**
**dass** oberhalb und/oder unterhalb der Tür (11) ein erstes und ein zweites Führungssystem (109, 114) an der Messkammer (101) angebracht ist.

7. Verschlussmechanismus gemäß Anspruch 6,
**dadurch gekennzeichnet,**
**dass** ein Führungssystem (109, 114) mindestens zwei Schienenabschnitte (106, 108) umfasst, die an einem Ende über ein Koppelelement (107) beweglich miteinander verbunden sind, und
**dass** die Schienenabschnitte (106, 108) am jeweils entgegengesetzten Endbereich (105) einen Schrägschlitz (110) aufweisen.

8. Verschlussmechanismus gemäß Anspruch 7,
**dadurch gekennzeichnet,**
**dass** das Koppelelement (107) beweglich gelagert ist und die Bewegung des Koppelelements (107) die mindestens zwei Schienenabschnitte (106, 108) parallel zur Tür (11) nach außen (125) führt.

9. Verschlussmechanismus gemäß Anspruch 7 oder 8,
**dadurch gekennzeichnet,**
**dass** mehrere Führungszapfen (104) in jeweils einen Schrägschlitz (110) im Führungssystem (109, 114) eingreifen und im Führungssystem (109, 114) linear in Richtung senkrecht (126) zur Tür (11) geführt sind.

10. Verschlussmechanismus gemäß einem der Ansprüche 1 bis 9,
**dadurch gekennzeichnet,**
**dass** die Tür durch die lineare Bewegung zwischen 1 cm und 5 cm, bevorzugt zwischen 2 cm und 3 cm verschoben wird.

11. Verschlussmechanismus gemäß einem der Ansprüche 1 bis 10,
**dadurch gekennzeichnet,**
**dass** die elektromagnetische Dichtung (13) als metallische Feder ausgebildet ist.

12. Verschlussmechanismus gemäß einem der Ansprüche 1 bis 2,
**dadurch gekennzeichnet,**
**dass** ein Spezialscharnier (200), bestehend aus einer Scharnierplatte (202) und einem Scharnierarm (201), die Tür (11) mit einer Seitenwand (116) der Messeinrichtung (100) verbindet.

13. Verschlussmechanismus gemäß Anspruch 12,
**dadurch gekennzeichnet,**
**dass** die Scharnierplatte einen Längsschlitz (205) und einen Drehschlitz (203) aufweist, in denen Scharnierzapfen (204, 206) des Scharnierarms (201) geführt sind, wobei der Drehschlitz (203) aus einem Längsabschnitt (208) und einem Bogenabschnitt (207) besteht.

## Claims

1. A closure mechanism for an electromagnetically sealed measuring station (100) with a test chamber (101), a door (11) for closing the test chamber (101) and an electromagnetic seal (13), wherein the door (11) provides at least one peripheral rebate (14) which engages in at least one groove (15) in the door frame (12),
**characterised in that**
the door (11) is attached in such a manner that it can be moved initially in a linear manner (16) away from the test chamber (101) and can then be pivoted in a rotational movement (17), so that the door (11) is guided out of the groove (15) in a linear movement exclusively perpendicular to the plane of the door.

2. The closure mechanism according to claim 1,
**characterised in that**
the electromagnetic seal (13) is fitted in at least one peripheral groove (15) in the door frame (12) of the test chamber (101).

3. The closure mechanism according to any one of claims 1 to 2,
**characterised in that**
at least one guide pin (104) is connected to the door (11) in a form-fit or material-fit manner.

4. The closure mechanism according to any one of claims 1 to 3,
**characterised in that**
the door (11) is built into an auxiliary frame (103), and the door (11) can be moved within the auxiliary frame (103) perpendicular to the plane of the closed door (11).

5. The closure mechanism according to claim 4,
**characterised in that**
the auxiliary frame (103) is connected in a pivoting manner by several rotary hinges (111) to a side wall (116) of the test chamber (101).

6. The closure mechanism according to any one of claims 1 to 5,
**characterised in that**
a first and a second guide system (109, 114) are attached to the test chamber (101) above and/or below the door (11).

7. The closure mechanism according to claim 6,
**characterised in that**
a guide system (109, 114) comprises at least two rail portions (106, 108), which are connected at one end via a coupling element (107) in a movable manner relative to one another, and
that the rail portions (106, 108) provide a diagonal slot (110) at the respectively opposite end region (105).

8. The closure mechanism according to claim 7,
**characterised in that**
the coupling element (107) is mounted in a movable manner, and the movement of the coupling element (107) guides the at least two rail portions (106, 108) outwards (125) parallel to the door (11).

9. The closure mechanism according to claim 7 or 8,
**characterised in that**
several guide pins (104) engage in each case in a diagonal slot (110) within the guide system (109, 114) and are guided in a linear manner within the guide system (109, 114) in the direction perpendicular (126) to the door (11).

10. The closure mechanism according to any one of claims 1 to 9,
**characterised in that**
the door is displaced by the linear movement between 1 cm and 5 cm, preferably between 2 cm and 3 cm.

11. The closure mechanism according to any one of claims 1 to 10,
**characterised in that**
the electromagnetic seal (13) is formed as a metallic spring.

12. The closure mechanism according to any one of claims 1 to 2,
**characterised in that**
a special hinge (200) comprising a hinge plate (202) and a hinge arm (201) connects the door (11) to a side wall (116) of the measuring station (100).

13. The closure mechanism according to claim 12,
**characterised in that**
the hinge plate provides a longitudinal slot (205) and a turning slot (203) in which hinge pins (204, 206) of the hinge arm (201) are guided, wherein the turning slot (203) comprises a longitudinal portion (208) and a curved portion (207).

## Revendications

1. Mécanisme de fermeture pour une installation de mesure rendue étanche électromagnétiquement (100) comportant une chambre de mesure (101), une porte (11) pour fermer la chambre de mesure (101) ainsi qu'une étanchéité électromagnétique (13), dans lequel la porte (11) comporte à sa périphérie au moins un pli (14), qui pénètre dans au moins une rainure (15) dans l'encadrement de porte (12),
**caractérisé en ce que**
la porte (11) est disposée de sorte qu'elle peut être éloignée d'abord linéairement (16) de la chambre de mesure (101) et ensuite pivoter selon un mouvement de rotation (17), de sorte que la porte (11) est sortie de la rainure (15) dans un mouvement linéaire uniquement vertical par rapport au plan de la porte.

2. Mécanisme de fermeture selon la revendication 1, **caractérisé en ce que**
l'étanchéité électromagnétique (13) est disposée dans au moins une rainure périphérique (15) dans l'encadrement de porte (12) de la chambre de mesure (101).

3. Mécanisme de fermeture selon la revendication 1 ou 2, **caractérisé en ce que**
au moins un tourillon de guidage (104) est relié à la porte (11) mécaniquement ou matériellement.

4. Mécanisme de fermeture selon l'une des revendications 1 à 3, **caractérisé en ce que**
la porte (11) est montée dans un encadrement auxiliaire (103) et la porte (11) peut être déplacée verticalement par rapport au plan de la porte fermée (11) dans l'encadrement auxiliaire (103).

5. Mécanisme de fermeture selon la revendication 4, **caractérisé en ce que**
l'encadrement auxiliaire (103) est relié de façon pivotante par plusieurs charnières rotatives (111) à une paroi latérale (116) de la chambre de mesure (101).

6. Mécanisme de fermeture selon l'une des revendications 1 à 5, **caractérisé en ce que**
un premier et un second système de guidage (109, 114) sont disposés dans la chambre de mesure (101) au-dessus et/ou au-dessous de la porte (11).

7. Mécanisme de fermeture selon la revendication 6, **caractérisé en ce que**
un système de guidage (109, 114) comprend au moins deux tronçons de rails (106, 108), qui sont reliés mobiles l'un par rapport à l'autre à une extrémité par l'intermédiaire d'un élément de couplage (107), et
**en ce que** les tronçons de rails (106, 108) comportent une fente oblique (110) dans la région terminale opposée respective (105).

8. Mécanisme de fermeture selon la revendication 7, **caractérisé en ce que**
l'élément de couplage (107) est monté mobile et le mouvement de l'élément de couplage (107) guide vers l'extérieur (125) les au moins deux tronçons de rails (106, 108) parallèlement à la porte (11).

9. Mécanisme de fermeture selon la revendication 7 ou 8, **caractérisé en ce que**
plusieurs tourillons de guidage (104) pénètrent dans une fente oblique respective (110) dans le système de guidage (109, 114) et sont guidés linéairement dans la direction verticale (126) par rapport à la porte (11) dans le système de guidage (109, 114).

10. Mécanisme de fermeture selon l'une des revendications 1 à 9, **caractérisé en ce que**
la porte est déplacée grâce au mouvement linéaire entre 1 cm et 5 cm, de préférence entre 2 cm et 3 cm.

11. Mécanisme de fermeture selon l'une des revendications 1 à 10, **caractérisé en ce que**
l'étanchéité électromagnétique (13) est réalisée sous la forme d'une feuille métallique.

12. Mécanisme de fermeture selon l'une des revendications 1 à 2, **caractérisé en ce que**
une charnière spéciale (200), constituée d'une plaque de charnière (202) et d'un bras de charnière (201), relie la porte (11) à un côté latéral (116) de l'installation de mesure (100).

13. Mécanisme de fermeture selon la revendication 12, **caractérisé en ce que**
la plaque de charnière comporte une fente longitudinale (205) et une fente rotative (203), dans lesquelles les tourillons de charnière (204, 206) du bras de charnière (201) sont guidés, où la fente rotative (203) est constituée d'un tronçon longitudinal (208) et d'un tronçon courbe (207).
